Europäisches Patentamt

European Patent Office

Office européen des brevets

(11) Veröffentlichungsnummer: **0 105 421**
**B1**

# EUROPÄISCHE PATENTSCHRIFT

(45) Veröffentlichungstag der Patentschrift:
**08.06.88**

(21) Anmeldenummer: **83109447.9**

(22) Anmeldetag: **22.09.83**

(51) Int. Cl.⁴: **G 03 F 7/02,** G 03 C 1/92,
G 03 C 11/12

(54) **Lichtempfindliches Schichtübertragungsmaterial und Verfahren zur Herstellung einer Photoresistschablone.**

(30) Priorität: **02.10.82 DE 3236560**

(43) Veröffentlichungstag der Anmeldung:
**18.04.84 Patentblatt 84/16**

(45) Bekanntmachung des Hinweises auf die Patenterteilung:
**08.06.88 Patentblatt 88/23**

(84) Benannte Vertragsstaaten:
**AT BE CH DE FR GB IT LI NL SE**

(56) Entgegenhaltungen:
**DE-A-2 106 574**
**DE-A-2 123 702**
**DE-A-2 403 487**
**US-A-1 591 304**
**US-A-3 010 390**
**US-A-3 909 328**
**US-A-4 232 108**

(73) Patentinhaber: **HOECHST AKTIENGESELLSCHAFT,
Postfach 80 03 20, D-6230 Frankfurt am Main 80
(DE)**

(72) Erfinder: **Geissler, Ulrich, Dr., Ruprechtstrasse 22,
D-6000 Frankfurt/Main (DE)**
Erfinder: **Herwig, Walter, Dr., Hasenpfad 7, D-6232
Bad Soden/Ts (DE)**
Erfinder: **Sikora, Helga, Bunsenstrasse 6F, D-6200
Wiesbaden (DE)**

**Beschreibung**

Die Erfindung betrifft ein lichtempfindliches Schichtübertragungsmaterial mit einer temporären flexiblen Trägerfolie und einer thermoplastischen lichtempfindlichen Schicht sowie ein Verfahren zur Herstellung einer Photoresistschablone, bei dem eine feste thermoplastische lichtempfindliche Schicht mittels eines Schichtübertragungsmaterials auf einen permanenten Träger übertragen und dort bildmäßig belichtet und entwickelt wird.

Schichtübertragungsverfahren und materialien der angegebenen Gattung sind z. B. in der DE-B-1 522 515 oder der US-A-4 193 797 beschrieben. Dort werden negativ oder positiv arbeitende thermoplastische lichtempfindliche Schichten unter Druck oder Erwärmen trocken auf einen permanenten Schichtträger übertragen, dort zur Photoresistschablone verarbeitet, und der permanente Schichtträger wird dann an den von der Schablone nicht abgedeckten Stellen modifiziert, z. B. geätzt oder galvanisiert.

In den DE-A-2 106 574 und 2 123 702 werden entsprechende Materialien beschrieben, bei denen zwischen lichtempfindlicher Schicht und temporärem Schichtträger eine nicht thermoplastische Zwischenschicht aufgebracht ist, die sich in dem zur Verarbeitung der lichtempfindlichen Schicht verwendeten Entwickler löst und die an der lichtempfindlichen Schicht stärker haftet als an dem temporären Schichtträger. Diese Materialien werden verarbeitet, indem die lichtempfindliche Schicht auf den permanenten Schichtträger laminiert und dann der temporäre Schichtträger von der Zwischenschicht abgezogen wird. Erst dann wird im Kontakt unter einer Vorlage belichtet und schließlich entwickelt. Da die bevorzugten Zwischenschichten wasserlöslich sind, haben sie die Neigung, an der Luft je nach deren Feuchte anzuquellen und Oberflächen unregelmäßiger Struktur auszubilden, die ein korrektes Belichten wesentlich erschweren oder sogar unmöglich machen.

Aus der US-A-4 278 752 ist auch die Herstellung von Lötstopmasken nach dem Trockenresistverfahren bekannt. Es wurde gefunden, daß bei dieser Anwendung, aber auch bei der zuvor genannten, die hochglänzende Oberfläche der Resistschicht, die nach dem Abziehen der temporären Trägerfolie zurückbleibt, in manchen Fällen störend ist. Auch kommt es unter bestimmten Lötbedingungen vor, daß nach dem Schwall-Löten Fäden oder Kügelchen der Lötlegierung an der Oberfläche der Lötstopmaske haften bleiben und unter Umständen zu Kurzschlüssen führen. Bei der glänzenden Oberfläche treten außerdem, insbesondere beim manuellen Bestücken, störende Reflexionen auf.

Im Falle eines Trockenresists bietet die matte Oberfläche aufgrund der im Vergleich zur Kupferoberfläche deutlich geringeren Reflexion die Möglichkeit der optischen Prüfung einer entwickelten Leiterplatte.

In der DE-A-2 403 487 sind photopolymerisierbare Reliefdruckplatten beschrieben, bei denen die Oberfläche der photopolymerisierbaren Schicht mattiert ist, um den Kontakt zwischen Vorlage und Schicht im Vakuumkopierrahmen zu verbessern und zu beschleunigen und um die Annahme von Druckfarbe beim flexographischen Druck zu verbessern (S. 3, 1. Absatz). Die Mattierung der Oberfläche kann u. a. durch Kontakt mit einer mattierten oder gekörnten Oberfläche, z. B. mit einer aufgerauhten Aluminiumplatte oder einem aufgerauhten Polyesterfilm, erfolgen, wobei die mattierte Oberfläche mit Silikon überzogen wird, um die anschließend erforderliche Ablösung von der Schicht zu ermöglichen. Die Verarbeitung einer lichtempfindlichen Druckplatte unterscheidet sich wesentlich von der eines Trockenresistmaterials, und die Aufgabe, die dort durch die Mattierung der Oberfläche der lichtempfindlichen Schicht gelöst wird, ist eine andere als sich, wie zuvor geschildert, bei der Verarbeitung von Trockenresist zu Lötstopmasken oder Resistschablonen ergibt.

In der US-A-3 909 328 ist ein Verfahren zum Übertragen dekorativer Schichten auf bestimmte Unterlagen, z. B. auf Leder, beschrieben. Die Dekorschicht wird durch Belichten einer auf einem temporären Träger befindlichen lichtempfindlichen Schicht zu einem Farbkontrastbild und ggf. Fixieren des Bilds erzeugt. Der temporäre Träger kann eine geprägte Oberfläche aufweisen, deren Muster als zusätzliches Dekor auf die lichtempfindliche Schicht übertragen wird. Diese Prägung muß naturgemäß, um sichtbar zu werden, eine Relieftiefe in der Größenordnung von einigen Hundert µm haben. Das Verfahren ist zur Herstellung von Photoresists oder Lötstopmasken weder bestimmt noch geeignet.

Aufgabe der Erfindung war es, ein Schichtübertragungsmaterial zur Verfügung zu stellen, das bei Verwendung von wasserlöslichen oder an feuchter Luft quellbaren Trennschichten keine Probleme beim Belichten ergibt und das nach dem Abziehen der temporaren Trägerfolie keine hochglänzende Schichtoberfläche aufweist.

Gegenstand der Erfindung ist ein lichtempfindliches Schichtübertragungsmaterial mit einer temporären flexiblen Trägerfolie, einer thermoplastischen photopolymerisierbaren Schicht und einer Deckfolie auf der der Trägerfolie abgewandten Oberfläche der photopolymerisierbaren Schicht, die an dieser Schicht weniger haftet als die Trägerfolie.

Das erfindungsgemäße Material ist dadurch gekennzeichnet, daß die der photopolymerisierbaren Schicht zugewandte Oberfläche der Trägerfolie eine mittlere Oberflächenrauhigkeit im Bereich von 0,5 bis 5 µm hat und daß diese Rauhigkeit auf die Oberfläche der photopolymerisierbaren Schicht übertragen wird.

Erfindungsgemäß wird ferner ein Verfahren zur Herstellung einer Photoresistschablone vorgeschlagen, bei dem man eine auf eine flexible transparente Trägerfolie aufgebrachte thermoplastische photopolymerisierbare Schicht mit ihrer freien Oberfläche auf einen permanenten Schichtträger laminiert, die photopolymerisierbare Schicht vor dem Abziehen der Trägerfolie durch diese hindurch bildmäßig belichtet und nach Abziehen der flexiblen Trägerfolie zum Reliefbild entwickelt.

Das erfindungsgemäße Verfahren ist dadurch gekennzeichnet, daß man eine Trägerfolie verwendet, deren Oberfläche, die die photopolymerisierbare Schicht trägt, eine mittlere Rauhigkeit im Bereich von 0,5 bis 5 μm hat, und daß diese Rauhigkeit auf die Oberfläche der photopolymerisierbaren Schicht übertragen wird.

Gemäß einer anderen Ausführungsform des erfindungsgemäßen Verfahrens wird ein Schichtübertragungsmaterial, das aus einer temporären flexiblen Trägerfolie, einer dünnen Zwischenschicht, die beim Erwärmen auf Temperaturen bis zu etwa 150°C nicht klebrig wird, einer thermoplastischen photopolymerisierbaren Schicht über der Zwischenschicht und einer Deckfolie auf der der Trägerfolie abgewandten Oberfläche der photopolymerisierbaren Schicht besteht, die an dieser Schicht weniger haftet als die Trägerfolie, wobei die Zwischenschicht an der photopolymerisierbaren Schicht stärker haftet als an der Trägerfolie und in einer Entwicklerflüssigkeit für die photopolymerisierbare Schicht löslich ist, nach Abziehen der Deckfolie mit der freien Oberfläche der photopolymerisierbaren Schicht auf einen permanenten Schichtträger laminiert, die temporäre Trägerfolie abgezogen, die lichtempfindliche Schicht bildmäßig belichtet und zum Reliefbild entwickelt.

Das Verfahren ist dadurch gekennzeichnet, daß man eine temporäre Trägerfolie verwendet, deren Oberfläche, auf der sich die Zwischenschicht und die lichtempfindliche Schicht befinden, eine mittlere Rauhigkeit im Bereich von 0,5 bis 5 μm hat, und daß diese Rauhigkeit auf die Zwischenschicht und ggf. auf die Oberfläche der photopolymerisierbaren Schicht übertragen wird.

Die Oberflächenrauhigkeit der temporären Trägerfolie kann durch mechanisches Aufrauhen, z. B. durch Sandstrahlen, oder durch Einverleiben von feinen Partikeln bewirkt werden. Bevorzugt wird eine Folie, die in ihrer Masse gleichmäßig verteilt Partikel, z. B. aus Siliciumdioxid, Talkum, Magnesiumoxid, Bornitrid, Aluminiumoxid oder hochschmelzenden unlöslichen organischen Substanzen, enthält. Die Menge der Teilchen beträgt vorzugsweise etwa 0,5 bis 6 Gew.-%, bezogen auf das Gewicht der Folie.

Die Rauhigkeit der Trägerfolie liegt im allgemeinen im Bereich von 0,5 bis 5 μm. Rauhigkeiten im oberen Teil des Bereichs werden bei dickeren photopolymerisierbaren Schichten, solche im unteren Teil bei dünnen Schichten, besonders bei Vorliegen der relativ dünnen Zwischenschichten, gewählt.

Wenn die Rauhigkeit der Folienoberfläche durch Einverleiben von Partikeln erzeugt wird, liegt deren Größe im Mittel etwas oberhalb der gewünschten Rauhigkeit; sie kann z. B. das 1,5- bis 2,5-fache davon betragen.

Die temporäre Trägerfolie soll in den Fällen, wo keine Zwischenschicht verwendet wird, transparent sein. In diesem Fall muß also die Menge und der Brechungsindex der Partikel so gewählt werden, daß die Transparenz nicht wesentlich beeinträchtigt wird. Die Kombination von Polyethylenterephthalatfolien mit Siliciumdioxid-Partikeln hat sich hierbei besonders bewährt. Allgemein kann die Folie aus den in der DE-A-2 123 702 angegebenen Materialien bestehen.

Für die Zwischenschicht sind ebenfalls die in der DE-A-2 123 702 genannten Materialien geeignet. Polyvinylalkohol, Polyvinylpyrrolidon und Acrylamidpolymerisate sind Beispiele für gut geeignete Substanzen. Die Dicke der Zwischenschicht beträgt etwa 0,05 bis 8 μm, vorzugsweise 1 bis 5 μm.

Von besonderem Vorteil kann es sein, wenn der Zwischenschicht mindestens ein Bestandteil der photopolymerisierbaren Schicht in kleiner Menge zugesetzt wird. Dadurch wird die Haftung an der photopolymerisierbaren Schicht und die Abtrennung von der Trägerfolie begünstigt. Diese Ausführungsform hat sich besonders bewährt, wenn von den Bestandteilen der photopolymerisierbaren Schicht vor allem die polymerisierbare Verbindung der Zwischenschicht zugesetzt wird.

Die photopolymerisierbare Schicht besteht im allgemeinen aus einer polymerisierbaren Verbindung, insbesondere einer Verbindung mit mindestens zwei Acryl- oder Methacrylsäurestergruppen, einem Photoinitiator für die Radikalkettenpolymerisation, einem polymeren Bindemittel und anderen üblichen Zusätzen. Derartige Schichten sind z. B. in der DE-B-1 522 515, den DE-A-2 123 702 und 3 036 694 und der US-A-4 278 752 beschrieben.

Die Rückseite der photopolymerisierbaren Schicht wird mit einer Deckfolie abgedeckt, die gegenüber der Schicht eine geringere Haftung hat als die temporäre Trägerfolie, z. B. mit einer Folie aus Polyethylen.

Die Verarbeitung des erfindungsgemäßen Materials erfolgt in der Weise, daß die Deckfolie entfernt und die freigelegte Oberfläche der thermoplastischen photopolymerisierbaren Schicht, vorzugsweise unter Druck und Erwärmen, auf den permanenten Träger, vorzugsweise eine Leiterplatte bzw. ein kupferkaschiertes Basismaterial, laminiert wird. Danach wird, wenn keine Zwischenschicht zwischen der temporären Trägerfolie und der photopolymerisierbaren Schicht vorhanden ist, durch die Trägerfolie belichtet, die letztere abgezogen und die belichtete Schicht entwickelt. Wenn es sich um eine Lötstopmaske handelt, wird diese nach dem Entwickeln getempert. Die Oberfläche der Resistschablone läßt sich durch ihr mattiertes Aussehen visuell gut von der freigelegten Kupferoberfläche unterscheiden, so daß die Beurteilung der Kopie erleichtert wird. Bei dem anschließenden Lötvorgang bleibt die matte Oberfläche der Lötmaske überraschenderweise frei von Fäden oder Kügelchen des Lötmetalls, z. B. einer Blei-Zinn-Legierung.

Wenn es sich um eine übliche Photoresistschablone handelt, wird nach dem Entwickeln das freigelegte Basismetall geätzt, oder es wird darauf Metall, zumeist auf galvanischem Wege, abgeschieden.

Wenn ein Material mit einer Zwischenschicht zwischen der Trägerfolie und der photopolymerisierbaren Schicht verarbeitet wird, wird nach dem Laminieren die Trägerfolie abgezogen und dann die Vorlage auf die von der rauhen Oberfläche der Trägerfolie geprägte Zwischenschicht aufgelegt. Die durch die Prägung strukturierte bzw. mattierte Zwischenschicht zeigt auch bei längerem Liegen an feuchter Luft keine Neigung zu unregelmäßigen Quellungs- oder Verzugserscheinungen, so daß eine einwandfreie Kontaktkopie ermöglicht wird.

Die photopolymerisierbare Schicht ist gegen Luftsauerstoff empfindlich. Es muß deshalb Sorge getragen werden, daß die Zwischenschicht nicht dünner ist als die Oberflächenrauhigkeit der Folie. Es besteht sonst die Gefahr, daß diese zugleich als Sauerstoffsperre dienende Schicht stellenweise unterbrochen ist und dort ihre Schutzfunktion verliert. Im allgemeinen ist es noch möglich, zusammenhängende Polyvinylalkoholschichten zu erhalten, wenn ihre Dicke nur geringfügig, etwa um wenige Zehntel um größer ist als die maximale Rauhigkeit der Folie.

Die Belichtung der erfindungsgemäßen Materialien erfolgt in bekannter Weise im Kontakt unter einer Transparentvorlage mit kurzwelligem sichtbarem oder ultraviolettem Licht der üblichen Kopierlampen. Die Bebilderung der Schichten kann auch durch Laserbestrahlung erfolgen. Hierbei ist es von besonderem Vorteil, daß sich die Erfindung auch in einer Herabsetzung der erforderlichen Lichtmenge, also einer Erhöhung der praktischen Lichtempfindlichkeit auswirkt.

Die folgenden Beispiele beschreiben bevorzugte Ausführungsformen der Erfindung. Wenn nichts anderes angegeben ist, sind Prozente und Mengenverhältnisse in Gewichtseinheiten zu verstehen. Gewichtsteile (Gt) und Volumteile (Vt) stehen im Verhältnis von g zu ccm.

## Beispiel 1

Es wurde eine Beschichtungslösung hergestellt aus:

| | | |
|---|---|---|
| 13 | Gt | eines Terpolymerisates aus n-Hexylmethacrylat, Methacrylsäure und Styrol (60 : 30 : 10) mit einem mittleren Molgewicht von ca. 35.000 und der Säurezahl 195, |
| 4,4 | Gt | Polyethylenglykol-400-dimethacrylat, |
| 1,6 | Gt | eines elastomeren Reaktionsprodukts aus Glycidylmethacrylat, Adipinsäure und einem oligomeren Diisocyanat, das durch Umsetzen von Tolylendiisocyanat mit einem Polybutan-1,4-diol erhalten worden ist, (vgl. DE-A-3 036 694), |
| 1 | Gt | Hexamethoxymethyl-melamin, |
| 0,2 | Gt | 9-Phenyl-acridin, |
| 0,01 | Gt | eines blauen Azofarbstoffs, erhalten durch Kuppeln von 2,4-Dinitro-6-chlor-benzol-diazoniumsalz mit 2-Methoxy-5-acetylamino-N,N-diethylanilin und |
| 0,03 | Gt | 1,4-Bis-(4-tert.butoxy-phenylamino)-5,8- dihydroxyanthrachinon in |
| 30 | Gt | Butanon und |
| 5,0 | Gt | Ethanol. |

Mit der Lösung wurden 110 cm breite Bahnen einer glatten sowie einer mit porösem Siliciumdioxid mit einem mittleren Teilchendurchmesser von 1 μm pigmentierten Polyethylenterephthalatfolie der Stärke 23 μm mittels einer Schlitzdüse kontinuierlich beschichtet. Nach Durchlaufen einer Trockenzone hatten die Resistschichten eine Dicke von jeweils 100 μm und wurden mit einer 25 μm dicken Polypropylenfolie abgedeckt. Die so gefertigten Trockenresistfolien wurden anschließend mittels eines Rollenschneiders zu handlichen Resistrollen einer Breite von 45 cm und einer Bahnlänge von 50 m zerschnitten

Für die Laminierversuche dienten Testplatten aus Epoxid-Glas-Hartgewebe mit ca. 65 μm starken Leiterbahnen aus Kupfer mit einer verzinnten Oberfläche und durchkontaktierten Löchern. Die Leiterbahnbreiten und -abstände lagen zwischen 200 und 1000 μm, die Lochdurchmesser betrugen 0,6 bis 4 mm.

Auf diese Platten wurden die 100 μm starken Lötresistschichten mit einer handelsüblichen Laminiervorrichtung bei 120°C laminiert.

Dann wurden die Platten durch eine Belichtungsvorlage, die die zu lötenden Augen und Löcher abdeckte, mit einem handelsüblichen Belichtungsgerät mit 5 kW-Metalhalogenid-Lampe 25 Sekunden belichtet, in einem handels üblichen Sprühprozessor 150 Sekunden mit 0,8-%-iger Sodalösung entwickelt und trockengeblasen. Die so präparierten Leiterplatten wurden dann in einem Trockenschrank 60 Minuten bei 150°C gehärtet. Die abgekühlten Platten wurden anschließend mit einem Flußmittel TL 33-16 der Firma Alpha Grillo benetzt und sodann mit einer Geschwindigkeit Von 1,0 m/min über ein handelsübliches Blei-Zinn-Schwallötbad von 250°C geführt.

Die mit der beschriebenen matten Lötstopmaske beschichteten Leiterplatten waren nach dem Löten und Reinigen völlig sauber.

Die von einer glatten Polyesterfolie übertragene Lötresistschicht ergab unter bestimmten Lötbedingungen (z. B. bei ungenügender Antrocknung des Flußmittelfilms) Fehler durch Anhaften von Kugeln oder Fäden des Lötmetalls auf der Lötstopmaske, die auch durch Reinigen nicht zu entfernen sind. Dies führt zu Kurzschlüssen, und die Leiterplatte ist unbrauchbar.

Offenbar ist die Haftung von Blei-Zinn-Partikeln auf einer matten, d. h. aufgerauhten Resistoberfläche geringer als auf einer glänzenden, d. h. ebenen Oberfläche.

## Beispiel 2

Es wurden Beschichtungslösungen wie in Beispiel 1 hergestellt, in denen das Polyethylenglykol-400-dimethacrylat durch folgende Monomere ersetzt wurde:

a) Umsetzungsprodukt aus 2,2,4-Trimethylhexamethylendiisocyanat und Hydroxyethylmethacrylat,

b) Umsetzungsprodukt aus Triethylenglykol, 2,2,4-Trimethylhexamethylendiisocyanat und Hydroxyethylmethacrylat,

c) 2,2-Bis-[-4-(2-acryloyloxy-propoxy)phenyl]propan.

Mit den Lösungen wurden wie in Beispiel 1 eine glatte sowie eine mit Kieselgel pigmentierte Polyesterfolie beschichtet und die Schichten nach dem Trocknen mit einer Polypropylenfolie kaschiert. Die Trockenresistfolien wurden wie in Beispiel 1 verarbeitet.

Auch hier zeigt sich, daß auf der matten Oberfläche der Lötstopmaske nach dem Löten keine Blei-Zinn-Reste haften, während dies bei der glänzenden Oberfläche unter ungünstigen Bedingungen der Fall ist.

## Beispiel 3

A. Die Lösung für die lichtempfindliche Schicht wurde wie folgt hergestellt:

6,5 Gt eines Terpolymerisats aus n-Hexylmethacrylat, Methacrylsäure und Styrol (60 : 30 : 10) mit einem mittleren Molgewicht von ca. 35.000 und der Säurezahl 195,

3,2 Gt Polyethylenglykol-400-dimethacrylat,

0,8 Gt des in Beispiel 1 angegebenen Elastomeren,

0,1 Gt 9-Phenyl-acridin,

0,035 Gt eines Azofarbstoffs, erhalten durch Kuppeln von 2-4-Dinitro-6-chlorbenzoldiazoniumsalz mit 2-Methoxy-5-acetylamino-N-cyanoethyl-N-hydroxyethyl-anilin,

10 Gt Methylethylketon und

1 Gt Ethanol.

B. Die Lösung für die Zwischenschicht wurde wie folgt hergestellt

200 Gt 7-%-ige wäßrige Polyvinylalkohol-Lösung,

1 Gt Polyethylenglykol-400-dimethacryalt,

0,002 Gt Kristallviolett

C. Die Beschichtungslösung A wurde auf eine biaxial verstreckte und thermofixierte Polyethylenterephthalatfolie der Stärke 25 µm, die mittels Lösung B mit einer ca. 1 µm dicken Trennschicht aus Polyvinylalkohol versehen war, so aufgeschleudert, daß nach dem Trocknen bei 100° C ein Schichtgewicht von 40 g/m$^2$ erhalten wurde.

D. Die Operation C wurde wiederholt, jedoch unter Verwendung einer Polyethylenterphtalatfolie, die durch Zusatz von ca. 1,5 Gew.-% porösem Siliziumdioxid mit einer mittleren Korngröße von 1 µm mit einer rauhen Oberfläche versehen war.

Die nach C und D erhaltenen Trockenresistfolien wurden mit einem handelsüblichen Laminiergerät bei 120° C auf mit 17,5 µm starker Kupferfolie kaschierte glasfaserverstärkte Epoxyharzplatten laminiert. Nach Abkühlen auf Raumtemperatur wurden die Polyesterfolien abgezogen.

Die Beschaffenheit der Oberflächen wurde in Abhängigkeit von Zeit und Luftfeuchtigkeit beobachtet und registriert:

| Lagerziet in Minuten | 2 | 2 | 4 | 4 | 1 | 80 | 180 |
|---|---|---|---|---|---|---|---|
| rel.Feuchte in % | 30 | 80 | 30 | 80 | | 30 | 80 |
| C | + glänzend | - | (-) | - | | - | - |
| D | matt + | matt + | matt + | matt + | | matt + | matt + |

+ brauchbare, unveränderte Oberfläche
(-) beginnendes unregelmäßiges Verziehen     unbrauchbare
- starkes, unregelmäßiges Verziehen     Oberflächen

**Beispiel 4**

Zur Herstellung von Trockenresistfolien in produktionstechnischem Maßstab wurde wie folgt Verfahren:

Mit einer Lösung der in Beispiel 3A angegebenen Zusammensetzung wurde wie in Beispiel 3D eine mit Polyvinylalkohol vorbeschichtete 100 cm breite Bahn einer 25 µm starken Polyesterfolie mit rauher Oberfläche mittels einer Schlitzdüse kontinuierlich beschichtet. Nach Durchlaufen einer Trockenzone hatte die Resistschicht eine Dicke von 38 µm und wurde mit einer Polypropylenfolie abgedeckt. Die so gefertigte Trockenresistfolie wurde auf einer Großrolle gespeichert. Die Großrolle wurde anschließend mittels eines Rollenschneiders zu handlichen Resistrollen einer Breite von 45 cm und einer Bahnlänge von 50 m zerschnitten. Durch Einstellen einer optimalen Wickelspannung wurde gewährleistet, daß die Rolle Lage für Lage gleichmäßig über dem Trägerkern aufgebaut saß und seitlich nicht abrutschte, d. h. nicht teleskopierte.

Zum Vergleich wurden mit der gleichen Beschichtungslösung Rollen hergestellt, bei denen jedoch unmattierte Polyesterfolie eingesetzt und keine Zwischenschicht aus Polyvinylalkohol verwendet wurde.

Die erhaltenen Folien wurden mit einer handelsüblichen Laminiervorrichtung bei 120°C auf eine mit 17,5 µm starker Kupferfolie kaschierte glasfaserverstärkte Epoxyharz-Schichtstoffplatte laminiert und dann - die Platten mit der Polyvinylalkohol-Zwischenschicht nach Abziehen der Trägerfolie - mit einem handelsüblichen Belichtungsgerät (5 kW Leistung) belichtet. Als Vorlage diente eine Strichvorlage mit Linienbreiten und -abständen bis herab zu 60 µm.

Nach der Belichtung wurden die Schichten mit einer 0,8-%-igen Natriumcarbonatlösung in einem Sprühentwicklungsgerät 60 Sekunden lang entwickelt.

Die Platten wurden 30 Sekunden mit Leitungswasser gespült, 30 Sekunden in einer 15-%-igen Ammoniumperoxydisulfat-Lösung angeätzt und dann 60 Minuten in einem Kupferelektrolytbad der Firma Schlötter, Geislingen/Steige, Typ "Glanzkupfer-Bad" galvanisiert.

Stromdichte: 2,5 A/dm$^2$

Metallaufbau: ca. 30 µm.

Die folgende Tabelle gibt die Lichtempfindlichkeit der beiden Resistmaterialien an Hand der Keilstufen des als Vorlage dienenden Stufenkeils und die Breite der galvanisch abgeschiedenen Kupferbahnen für drei verschiedene Vorlagenbreiten an.

| Bel. zeit Sekunden | 1 | 2 | 3 | 4 | 5 | 6 | 7 |
|---|---|---|---|---|---|---|---|
| Keilstufen Beispiel 4 | 4,7 | 5,1 | 5,9 | 6,0 | 6,8 | 7,1 | 7,4 |
| Keilstufen Vergleichsmüster | 3,1 | 4,0 | 4,6 | 5,0 | 5,5 | 6,0 | 6,5 |
| Breite der Cu-bahn bei 198 µm Breite in der Vorlage Beispiel 4 | 198 | 190 | 186 | 180 | 178 | 176 | 174 |
| Cu-Bahnbereite Vergleichsmuster | 220 | 210 | 207 | 198 | 192 | 187 | 180 |
| Cu-Bahnbreite bei 102 µm Breite in der Vorlage Beispiel 4 | 102 | 98 | 94 | 91 | 88 | 85 | 80 |
| Cu-Bahnbreite Vergleichsmuster | - | 110 | 102 | 96 | 92 | - | - |
| Cu-Bahnberite bei 76 µm Breite in der Vorlage Beispiel 4 | 75 | 70 | 68 | 66 | 64 | - | - |

Cu-Bahnbreite ⇐ abnehmende Entwicklerreisistenz ⇐

Vergleichsmuster ⇒ Verschlechterung der Bahnbreiten ⇒

# 0 105 421

**Beispiel 5**

Mit der in Beispiel 4 beschriebenen Trockenresistfolie wurde bei 120°C eine mit 17,5 μm starker Kupferfolie kaschierte glasfaserverstärkte Epoxyharz-Schichtstoffplatte von 25 x 16 cm laminiert. Nach 10 Minuten Lagerung wurde die Trägerfolie abgezogen. An einem handelsüblichen Laserbestrahlungsgerät (Laserite® 15OR der Eocom Division der American Hoechst Corp.), das mit einem Argon-Ionen-Laser ausgerüstet war, wurde die Platte mit 150 mW und 1200 Linien/2,54 cm (entsprechend 4 mJ/cm$^2$) bestrahlt. Das Laserite-Gerät wurde dabei mit einem zwischengeschalteten Rechner gekoppelt, so daß über eine immaterielle Vorlage ein Schaltungsbild auf der Resistschicht erzeugt wurde. Das immaterielle Bild enthielt Geraden und Bögen in verschiedenen Winkellagen zur Erzeugung von Linienbreiten und Linienabständen zwischen 200 μm und 70 μm. Nach der Bestrahlung wurde die Platte in 0,8-%-iger Natriumcarbonatlösung entwickelt. Die Resistflanken an den Leiterbahnen waren konturenscharf. Die Resistschablone war eine genaue Wiedergabe der immateriellen Vorlage, unabhängig von der Lage und Gestalt der gespeicherten Bahnen.

Die gehärtete Resistschablone zeigte eine sehr gute Resistenz gegenüber galvanischen Bädern, so daß die Platte z. B. in dem in Beispiel 4 angegebenen Glanzkupferbad mit fehlerfreien und festhaftenden Kupferbahnen versehen werden konnte.

**Beispiel 6**

Zur Herstellung eines positiv arbeitenden Trockenresistmaterials wurden die folgenden Beschichtungslösungen hergestellt:

A. Lichtempfindliche Schicht:

34,5 Gt Ethylenglykolmonomethylether,
21,0 Gt Butanon,
27,5 Gt eines Kresol-Formaldehyd-Novolaks mit einem Erweichungsbereich von 105-120°C nach Kapillar-Methode DIN 53181,
5,4 Gt Polyethylenglykol (Molgewicht 2000),
9,7 Gt des Polyacetals aus 2-Ethyl-butyraldehyd und Triethylenglykol,
0,3 Gt 2-(4-Ethoxy-napth-1-yl)-4,6-bis-trichlor-methyl-s-triazin,
1,9 Gt handelsübliches Lackhilfsmittel auf Silikonbasis und
0,02 Gt Kristallviolett-Base.

B. Zwischenschicht:

200 Gt 7-%-ige wäßrige Polyvinylalkohollösung und
1 Gt Polyethylenglykol (MG 2000).

Auf eine biaxial verstreckte und thermofixierte Polyethylenterephthalatfolie mit rauher Oberfläche, die 1,5 Gew.-% pyrogenes Siliciumdioxid mit der mittleren Korngröße 1 μm enthielt, wurde mittels Lösung B eine 1,4 bis 1,8 μm dicke Polyvinylalkoholschicht aufgebracht und darauf die Beschichtungslösung A so aufgeschleudert, daß nach dem Trocknen bei 90 - 110°C ein Schichtgewicht von 45 g/m$^2$ erhalten wurde.

Die so erhaltene Trockenresistfolie wurde mit einem handelsüblichen Laminiergerät bei 110°C auf eine mit 17,5 μm starker Kupferfolie kaschierte glasfaserverstärkte Epoxyharzplatte laminiert. Nach 10 Minuten Abkühlen ließ sich die Polyesterfolie problemlos abziehen. Die seidenmatte Oberfläche der Polyvinylalkoholschicht änderte sich auch nach mehr als 2 Stunden Lagerung in einem Raum von 70 % relativer Feuchte bei 25°C nicht.

Die beschichtete Platte wurde wie üblich unter einer Vorlage belichtet und mit 3,5-%-iger Trinatriumphosphatlösung entwickelt. Die freigelegten Kupferbahnen wurden mit Eisen-III-chloridlösung weggeätzt, und es wurde ein Schaltbild mit glatten Flanken erhalten.

**Patentansprüche**

1. Lichtempfindliches Schichtübertragungsmaterial mit einer temporären flexiblen Trägerfolie, einer thermoplastischen photopolymerisierbaren Schicht und einer Deckfolie auf der der Trägerfolie abgewandten Oberfläche der photopolymerisierbaren Schicht, die an dieser Schicht weniger haftet als die Trägerfolie, dadurch gekennzeichnet, daß die der photopolymerisier baren Schicht zugewandte Oberfläche der Trägerfolie eine mittlere Oberflächenrauhigkeit im Bereich von 0,5 bis 5 μm hat und daß diese Rauhigkeit auf die Oberfläche der photopolymerisierbaren Schicht übertragen wird.

2. Lichtempfindliches Schichtübertragungsmaterial nach Anspruch 1, dadurch gekennzeichnet, daß die Trägerfolie transparent ist.

3. Lichtempfindliches Schichtübertragungsmaterial nach Anspruch 1, dadurch gekennzeichnet, daß zwischen der photopolymerisierbaren Schicht und der Trägerfolie eine dünne Zwischenschicht angebracht ist, die an der photopolymerisierbaren Schicht stärker haftet als an der Trägerfolie, die beim Erwärmen auf Temperaturen bis zu 150°C nicht klebrig wird und die in einer Entwicklerflüssigkeit für die photopolymerisierbare Schicht löslich ist.

4. Lichtempfindliches Schichtübertragungsmaterial nach Anspruch 3, dadurch gekennzeichnet, daß die Zwischenschicht 1 bis 5 μm dick ist.

5. Lichtempfindliches Schichtübertragungsmaterial nach Anspruch 3, dadurch gekennzeichnet, daß die Zwischenschicht wasserlöslich ist.

6. Lichtempfindliches Schichtübertragungsmaterial nach Anspruch 3, dadurch gekennzeichnet, daß die Zwischenschicht einen kleineren Anteil an mindestens einem Bestandteil der photopolymerisierbaren Schicht enthält.

7. Verfahren zur Herstellung einer Photoresistschablone, bei dem man eine auf eine flexible transparente Trägerfolie aufgebrachte thermoplastische photopolymerisierbare Schicht mit ihrer freien Oberfläche auf einen permanenten Schichtträger laminiert, die photopolymerisierbare Schicht vor dem Abziehen der Trägerfolie durch diese hindurch bildmäßig belichtet und nach Abziehen der flexiblen Trägerfolie durch Auswaschen der unbelichteten Schichtbereiche zum Reliefbild entwickelt, dadurch gekennzeichnet, daß man eine Trägerfolie verwendet, deren Oberfläche, die die photopolymerisierbare Schicht trägt, eine mittlere Rauhigkeit im Bereich von 0,5 bis 5 μm hat und daß diese Rauhigkeit auf die Oberfläche der photopolymerisierbaren Schicht übertragen wird.

8. Verfahren zur Herstellung einer Photoresistschablone, bei dem man ein Schichtübertragungsmaterial, bestehend aus einer temporären flexiblen Trägerfolie, einer dünnen Zwischenschicht, die beim Erwärmen auf Temperaturen bis zu 150°C nicht klebrig wird, einer thermoplastischen photopolymerisierbaren Schicht über der Zwischenschicht und einer Deckfolie auf der der Trägerfolie abgewandten Oberfläche der photopolymerisierbaren Schicht, die an dieser Schicht weniger haftet als die Trägerfolie, wobei die Zwischenschicht an der photopolymerisierbaren Schicht stärker haftet als an der Trägerfolie und in einer Entwicklerflüssigkeit für die photopolymerisierbare Schicht löslich ist, nach Abziehen der Deckfolie mit der freien Oberfläche der photopolymerisierbaren Schicht auf einen permanenten Schichtträger laminiert, die temporäre Trägerfolie abzieht, die lichtempfindliche Schicht bildmäßig belichtet und zum Reliefbild entwickelt, dadurch gekennzeichnet, daß man eine temporäre Trägerfolie verwendet, deren Oberfläche, auf der sich die Zwischenschicht und die lichtempfindliche Schicht befinden, eine mittlere Rauhigkeit im Bereich von 0,5 bis 5 μm hat, und daß diese Rauhigkeit auf die Zwischenschicht und ggf. auf die Oberfläche der photopolymerisierbaren Schicht übertragen wird.

**Claims**

1. Photosensitive layer transfer material comprising a temporary flexible support film, a thermoplastic photopolymerizable layer and a cover film provided on that surface of the photopolymerizable layer which faces away from the support film, and adhering less firmly to the photopolymerizable layer than the support film does, wherein the average surface roughness of that surface of the support film which faces the photopolymerizable layer is in the range from 0,5 to 5 μm, and wherein said roughness is transferred to the surface of the photopolymerizable layer.

2. A photosensitive layer transfer material as claimed in claim 1, wherein the support film is transparent.

3. A photosensitive layer transfer material as claimed in claim 1, wherein, between the photopolymerizable layer and the support film, a thin intermediate layer is provided, which adheres more firmly to the photopolymerizable layer than to the support film, which does not become tacky when it is heated to temperatures up to 150°C and which is soluble in a developing liquid used for the photopolymerizable layer.

4. A photosensitive layer transfer material as claimed in claim 3, wherein the intermediate layer has a thickness ranging from 1 to 5 μm.

5. A photosensitive layer transfer material as claimed in claim 3, wherein the intermediate layer is watersoluble.

6. A photosensitive layer transfer material as claimed in claim 3, wherein the intermediate layer comprises a minor amount of at least one constituent of the photopolymerizable layer.

7. A process for manufacturing a photoresist stencil, which comprises laminating the free surface of a thermoplastic photopolymerizable layer applied to a flexible transparent support film onto a permanent layer support, imagewise exposing the photopolymerizable layer through the support film prior to peeling off the latter and developing the photopolymerizable layer into a relief image by washing out the unexposed layer areas after the flexible support film has been removed, the process being characterized in that a support film is employed, of which that surface to which the photopolymerizable layer is applied has an average roughness in the range from 0,5 to 5 μm and in that this roughness is transferred to the surface of the photopolymerizable layer.

8. A process for manufacturing a photoresist stencil, which comprises using a layer transfer material comprised of a temporary flexible support film, a thin intermediate layer which does not become tacky when it is heated to temperatures up to 150°C, a thermoplastic photopolymerizable layer applied on top of the intermediate layer, and a cover film provided on that surface of the photopolymerizable layer, which faces away from the support film, and adhering less firmly to the photopolymerizable layer than the support film does, the intermediate layer adhering more firmly to the photopolymerizable layer than to the support film and being soluble in a developing liquid used for the photopolymerizable layer, laminating the layer transfer material with the free surface of the photopolymerizable layer to a permanent layer support, peeling off the temporary support film, imagewise exposing the photosensitive layer and developing it into a relief image, the process being characterized in that a temporary support film is employed, of which that surface to which the intermediate layer and the photosensitive layer are applied has an average roughness in the range from 0,5 to 5 μm and in that this roughness is transferred to the intermediate layer and possible also to the surface of the photopolymerizable layer.

**Revendications**

1. Matériau de transfert de couche photosensible comprenant une feuille support temporaire flexible, une couche thermoplastique photopolymérisable et une feuille de recouvrement qui est placée sur la surface de la couche photopolymérisable située à l'opposé de la feuille support, et qui adhère moins à cette couche que la feuille support, caractérisé en ce que la surface de la feuille support dirigée vers la couche photopolymérisable possède une rugosité superficielle moyenne de l'intervalle de 0,5 à 5 μm et que cette rugosité est transférée à la surface de la couche photopolymérisable.

2. Matériau de transfert de couche photosensible selon la revendication 1, caractérisé en ce que la feuille support est transparente.

3. Matériau de transfert de couche photosensible selon la revendication 1, caractérisé en ce que, entre la couche photopolymérisable et la feuille support, est interposée une couche intermédiaire mince qui adhère plus fortement à la couche photopolymérisable qu'à la feuille support, qui ne devient pas collante lorsqu'on la chauffe à des températures allant jusqu'à 150°C, et qui est soluble dans un liquide développateur de la couche photopolymérisable.

4. Matériau de transfert de couche photosensible selon la revendication 3, caractérisé en ce que la couche intermédiaire est d'une épaisseur de 1 à 5 μm.

5. Matériau de transfert de couche photosensible selon la revendication 3, caractérisé en ce que la couche intermédiaire est soluble dans l'eau.

6. Matériau de transfert de couche photosensible selon la revendication 3, caractérisé en ce que la couche intermédiaire contient une petite proportion d'au moins un constituant de la couche photopolymérisable.

7. Procédé de préparation d'un pochoir en matériau de réserve photographique, dans lequel on lamine une couche thermoplastique photopolymérisable dépose sur une feuille support transparente flexible sur un support de couche permanent en appliquant sa surface libre sur ce support, puis, avant d'enlever la feuille support, on expose la couche photopolymérisable à une image a travers cette feuille support, puis, après avoir enlevé la feuille support flexible, on développe en éliminant par lavage les régions non exposées de la couche pour obtenir une image en relief, caractérisé en ce qu'on utilise une feuille support dont la surface qui porte la couche photopolymérisable possède une rugosité moyenne de l'intervalle de 0,5 à 5 μm et en ce que cette rugosité est transférée à la surface de la couche photopolymérisable.

8. Procédé de préparation d'un pochoir en matériau de réserve photographique dans lequel on lamine sur un support de couche permanent une matière de transfert de couche composée d'une feuille support temporaire flexible, d'une couche intermédiaire mince qui ne devient pas collante lorsqu'on la chauffe à des températures pouvant atteindre jusqu'à 150°C, d'une couche thermoplastique photopolymérisable placée sur la couche intermédiaire, et d'une feuille de recouvrement qui est placée sur la surface de la couche photopolymérisable située à l'opposé de la feuille support, et qui adhère moins à cette couche que la feuille support, la couche intermédiaire adhérant plus fortement à la couche photopolymérisable qu'à la couche support et étant soluble dans un liquide développateur de la couche photopolymérisable, le laminage s'effectuant après avoir enlevé la feuille de recouvrement et en disposant la surface libre de la couche photopolymérisable contre le support de couche permanent, puis on enlève la feuille support temporaire, on expose la couche photosensible à une image et on développe pour obtenir une image en relief, caractérisé en ce qu'on utilise une feuille support temporaire dont la surface sur laquelle se trouvent la couche intermédiaire et la couche photosensible possède une rugosité moyenne contenue dans l'intervalle de 0,5 à 5 μm et en ce que cette rugosité est transférée à la couche intermédiaire et, éventuellement à la surface de la couche photopolymérisable.